(19) Europäisches Patentamt
European Patent Office
Office européen des brevets

(11) **EP 4 786 635 A2**

(12) **EUROPEAN PATENT APPLICATION**

(43) Date of publication:
**05.08.2026 Bulletin 2026/32**

(21) Application number: **26150664.6**

(22) Date of filing: **07.01.2026**

(51) International Patent Classification (IPC):
*C23C 16/455* (2006.01)   *C23C 16/44* (2006.01)

(52) Cooperative Patent Classification (CPC):
**C23C 16/45561; C23C 16/4408**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **30.01.2025 JP 2025013937**

(71) Applicant: **Kokusai Electric Corp.**
**Tokyo 100-0004 (JP)**

(72) Inventors:
• **YAMAMOTO, Takayuki**
  **Toyama-shi, 939-2393 (JP)**
• **TANAKA, Shoki**
  **Toyama-shi, 939-2393 (JP)**

(74) Representative: **Verscht, Thomas Kurt Albert**
**Josephsburgstrasse 88 A**
**81673 München (DE)**

(54) **SUBSTRATE PROCESSING APPARATUS, SUBSTRATE PROCESSING METHOD, METHOD OF MANUFACTURING SEMICONDUCTOR DEVICE AND PROGRAM**

(57) To easily supply a large flow rate of a process gas into a process chamber, a technique includes: a first flow path one end of which is connected to a first supply source configured to supply a process gas and the other end of which is connected to a process chamber in which a substrate is processed; a first opening/closing structure provided at the first flow path; a second opening/closing structure provided at the first flow path between the first opening/closing structure and the process chamber; a second flow path one end of which is connected to the first flow path between the first opening/closing structure and the second opening/closing structure and the other end of which is connected to an exhaust apparatus; a storage provided at the second flow path; and a third opening/-closing structure provided at the second flow path between the storage and the exhaust apparatus.

EP 4 786 635 A2

## Description

### [Technical Field]

The present disclosure relates to a substrate processing apparatus, a substrate processing method, a method of manufacturing a semiconductor device and a program.

### [Related Art]

As a part of a manufacturing process of a semiconductor device or a substrate processing, a gas may be stored in a storage (gas reservoir) and then supplied from the storage into a process chamber and a substrate (for example, see Patent Document 1).

### [Related Art Document]

### [Patent Document]

Patent Document 1: Japanese Patent Laid-Open No. 2004-6801.

### [Disclosure]

### [Technical Problem]

According to the present disclosure, there is provided a technique capable of easily supplying a large flow rate of a process gas into a process chamber.

### [Technical Solution]

According to an embodiment of the present disclosure, there is provided a technique that includes: a first flow path one end of which is connected to a first supply source configured to supply a process gas and the other end of which is connected to a process chamber in which a substrate is processed; a first opening/closing structure provided at the first flow path; a second opening/closing structure provided at the first flow path between the first opening/closing structure and the process chamber; a second flow path one end of which is connected to a location in the first flow path between the first opening/closing structure and the second opening/closing structure and the other end of which is connected to an exhaust apparatus; a storage provided at the second flow path; and a third opening/closing structure provided at the second flow path between the storage and the exhaust apparatus.

### [Advantageous Effects]

According to some embodiments of the present disclosure, it is possible to easily supply a large flow rate of a process gas into a process chamber from a storage.

### [Brief Description of Drawings]

FIG. 1 is a diagram schematically illustrating a vertical cross-section of a process furnace (vertical type process furnace) of a substrate processing apparatus preferably used in one or more embodiments of the present disclosure.
FIG. 2 is a block diagram schematically illustrating a configuration of a controller and its related components of the substrate processing apparatus preferably used in the embodiments of the present disclosure.
FIG. 3 is a diagram schematically illustrating an exemplary flow of a substrate processing according to the embodiments of the present disclosure.
FIG. 4 is a diagram schematically illustrating a plurality of steps in a step S31 according to the embodiments of the present disclosure and states of valves in each step.
FIG. 5 is a diagram schematically illustrating a plurality of steps in a step S6 according to the embodiments of the present disclosure and states of valves in each step.
FIG. 6 is a diagram schematically illustrating a source gas supplier according to a third modified example of the present disclosure.

FIG. 7 is a diagram schematically illustrating a plurality of steps in a step S31' according to the third modified example of the present disclosure and states of valves in each step.

FIG. 8 is a diagram schematically illustrating a plurality of steps in a step S6' according to the third modified example of the present disclosure and states of valves in each step.

**[Detailed Description]**

<Embodiments of Present Disclosure>

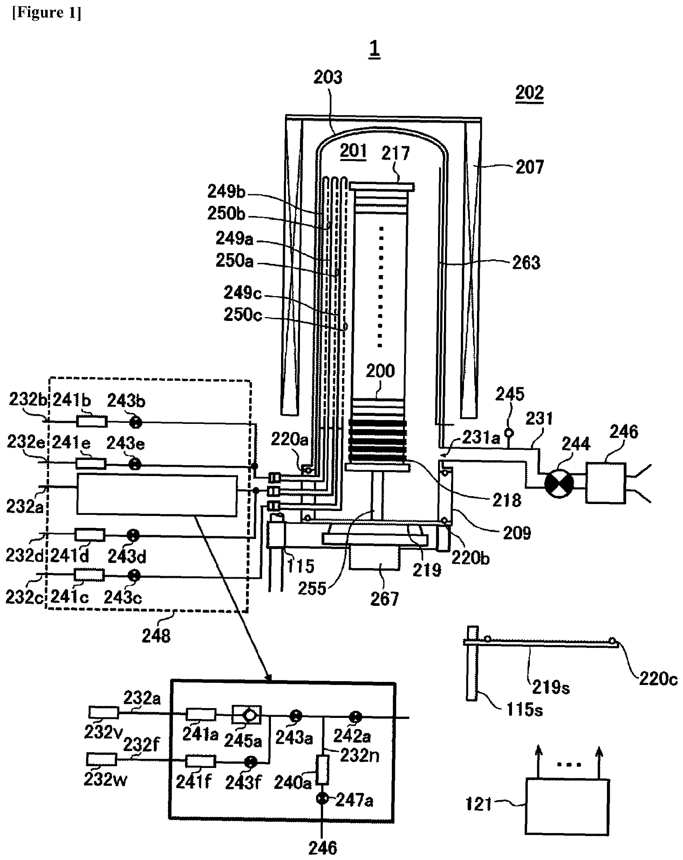

Hereinafter, one or more embodiments (hereinafter, also simply referred to as "embodiments") according to the present disclosure will be described mainly with reference to FIGS. 1 to 8. For example, the drawings used in the following description are all schematic, and a relationship between dimensions of each component and a ratio of each component shown in the drawing may not always match the actual ones. In addition, even between the drawings, the relationship between the dimensions of each component and the ratio of each component may not always match.

(1) Configuration of Processing Apparatus

As shown in FIG. 1, a process furnace 202 of a substrate processing apparatus 1 includes a heater 207 serving as a temperature regulator (which is a temperature adjusting structure or a heating structure). The heater 207 also functions as an activator (also referred to as an "exciter") capable of activating (or exciting) a gas by a heat.

A reaction tube 203 (which is of a cylindrical shape with a closed upper end and an open lower end) is provided in an inner side of the heater 207. A manifold 209 (which is of a cylindrical shape) is provided under the reaction tube 203. An O-ring 220a serving as a seal is provided between the manifold 209 and the reaction tube 203. A process vessel (also referred to as a "reaction vessel") is constituted mainly by the reaction tube 203 and the manifold 209. A process chamber 201 is provided in a hollow cylindrical portion of the process vessel. The process chamber 201 is configured to accommodate a plurality of wafers 200 therein. Hereinafter, each of the plurality of wafers 200 may also be referred to as a "wafer 200" serving as a substrate. In addition, the substrate may also be referred to as a "substrate 200". The wafer 200 is processed in the process chamber 201.

Nozzles 249a, 249b and 249c are provided in the process chamber 201. The nozzles 249a, 249b and 249c may serve as a first supply structure, a second supply structure and a third supply structure, respectively. The nozzles 249a, 249b and 249c may also be referred to as a first nozzle, a second nozzle and a third nozzle, respectively. Gas supply pipes 232a, 232b and 232c are connected to the nozzles 249a, 249b and 249c, respectively.

As shown enlarged in FIG. 1, for example, an upstream side (one end) of the gas supply pipe 232a serving as a first flow path is connected to a vaporizer 232v serving as a first supply source configured to supply a process gas (source gas), and a downstream side (the other end) of the gas supply pipe 232a is connected to the process chamber 201. Hereinafter, the gas supply pipe 232a may also be referred to as the "first flow path 232a", and the vaporizer 232v may also be referred to as the "first supply source 232v". A mass flow controllers (also simply referred to as "MFC") 241a serving as a flow rate controller (flow rate control structure), a check valve 245a, a valve 243a serving as a first opening/closing structure (which is an opening/closing valve) and a valve 242a serving as a second opening/closing structure (which is an opening/closing valve) are sequentially installed at the gas supply pipe 232a in this order from an upstream side to a downstream side of the gas supply pipe 232a in a gas flow direction. Hereinafter, the valve 243a may also be referred to as the "first opening/closing structure 243a", and the valve 242a may also be referred to as the "second opening/closing structure 242a". The check valve 245a is provided to prevent a backflow of the process gas from a storage (gas reservoir) 240a (described later) toward the vaporizer 232v. In such a configuration, the storage 240a is configured to store therein, as the process gas, the source gas obtained by phase-changing a liquid or a solid using the vaporizer 232v.

One end of a gas supply pipe 232n serving as a second flow path is connected to a location (portion) in the gas supply pipe 232a between the valve 243a and the valve 242a, and the other end of the gas supply pipe 232n is connected to an exhaust apparatus 246. Hereinafter, the gas supply pipe 232n may also be referred to as the "second flow path 232n". The storage (gas reservoir) 240a configured to temporarily store a gas and a valve 247a serving as a third opening/closing structure are installed at the gas supply pipe 232n. The valve 247a is provided at the gas supply pipe 232n between the storage (gas reservoir) 240a and the exhaust apparatus 246. Hereinafter, the valve 247a may also be referred to as the "third opening/closing structure 247a".

A gas supply pipe 232f serving as a third flow path is connected to a downstream of the MFC 241a in the gas supply pipe 232a between the check valve 245a and the valve 243a. Hereinafter, the gas supply pipe 232f may also be referred to as the "third flow path 232f". One end of the gas supply pipe 232f is connected to a second supply source 232w configured to supply a purge gas, and the other end of the gas supply pipe 232f is connected to the gas supply pipe 232a between the check valve 245a and the valve 243a. An MFC 241f and a valve 243f serving as a fourth opening/closing structure are sequentially installed at the gas supply pipe 232f in this order from an upstream side to a downstream side of the gas supply pipe 232f in the gas flow direction. Hereinafter, the valve 243f may also be referred to as the "fourth opening/closing structure 243f". A gas supply pipe 232d is connected to the gas supply pipe 232a at a downstream side of the valve 242a. An MFC 241d and a valve 243d are sequentially installed at the gas supply pipe 232d in this order from an upstream side to a downstream side of the gas supply pipe 232d in the gas flow direction. According to the present embodiments, as shown in FIG. 1, it is preferable that no other opening/closing structures (valves) are provided at the first flow path 232a between the first opening/closing structure 243a and the second opening/closing structure 242a, and at the second flow path 232n between the first flow path 232a and the storage 240a.

For example, the storage 240a is configured as spiral piping or a gas tank whose gas capacity is greater than ordinary piping. By opening and closing the valve 242a at a downstream side of the storage 240a and the valve 243a at an upstream side of the storage 240a, it is possible to fill the storage 240a with the gas supplied through the gas supply pipe 232a, and it is also possible to supply the gas filled in the storage 240a into the process chamber 201.

MFCs 241b and 241c and valves 243b and 243c serving as opening/closing valves (also referred to as "opening/closing structures") are sequentially installed at the gas supply pipes 232b and 232c, respectively, in this order from upstream sides to downstream sides of the gas supply pipes 232b and 232c in the gas flow direction. A gas supply pipe 232e is connected to the gas supply pipe 232b at a downstream side of the valve 243b. An MFC 241e and a valve 243e are sequentially installed at the gas supply pipe 232e in this order from an upstream side to a downstream side of the gas supply pipe 232e in the gas flow direction.

Each of the nozzles 249a to 249c is installed in an annular space provided between an inner wall of the reaction tube 203 and the wafers 200 when viewed from above, and extends upward from a lower portion toward an upper portion of the reaction tube 203 along the inner wall of the reaction tube 203. When viewed from above, each of the nozzles 249a to 249c is arranged so as to face an exhaust port 231a described later with the wafer 200 transferred (loaded) in the process chamber 201 interposed therebetween. A plurality of gas supply holes 250a, a plurality of gas supply holes 250b and a plurality of gas supply holes 250c are provided at side surfaces of the nozzles 249a, 249b and 249c, from lower portions to upper portions of the nozzles 249a, 249b and 249c, respectively. Gases are supplied to the wafers 200, through the gas supply holes 250a, the gas supply holes 250b and the gas supply holes 250c, respectively.

The source gas is supplied into the process chamber 201 through the gas supply pipe 232a (which is provided with the MFC 241a, the valve 243a, the storage 240a and the valve 242a) and the nozzle 249a. In addition, the source gas in the storage 240a can be exhausted through the exhaust apparatus 246 via the gas supply pipe 232n and the valve 247a. A reactive gas is supplied into the process chamber 201 through the gas supply pipe 232b (which is provided with the MFC 241b and the valve 243b) and nozzle 249b. In addition, the reactive gas is a substance whose molecular structure (chemical structure) is different from that of the source gas.

An inert gas can be supplied into the storage 240a through the gas supply pipe 232f (which is provided with the MFC 241f and the valve 243f) and the gas supply pipe 232n. The inert gas is supplied into the process chamber 201 through the gas supply pipes 232d and 232e (which are provided with the MFCs 241d and 241e and the valves 243d and 243e, respectively), the gas supply pipes 232a and 232b and the nozzles 249a and 249b, respectively. In addition, the inert gas is supplied into the process chamber 201 through the gas supply pipe 232c (which is provided with the MFC 241c and the valve 243c) and nozzle 249c. For example, the inert gas may act as a purge gas, a carrier gas, a dilution gas and the like.

A source gas supplier (which is a source gas supply structure) is constituted mainly by the gas supply pipes 232a and 232n, the MFC 241a, the valves 243a and 242a, and the storage 240a. The source gas supplier may also be referred to as a "source gas supply line". A reactive gas supplier which is a reactive gas supply structure) is constituted mainly by the gas supply pipe 232b, the MFC 241b and the valve 243b. The reactive gas supplier may also be referred to as a "reactive gas supply line". An inert gas supplier (which is an inert gas supply structure) is constituted mainly by the gas supply pipes 232c to 232e, the MFCs 241c to 241e and the valves 243c to 243e. The inert gas supplier may also be referred to as an "inert gas supply line". In addition, the source gas and the reactive gas may also be collectively or individually referred to as the "process gas" or a "film forming gas". Thus, the source gas supplier and the reactive gas supplier may also be collectively or individually referred to as a "process gas supplier" which is a process gas supply structure, or a "film forming gas supplier" which is a film forming gas supply structure. The process gas supplier may also be referred to as a "process gas supply line", and the film forming gas supplier may also be referred to as a "film forming gas supply line".

The exhaust port 231a connected to an exhaust pipe 231 is provided at a lower portion of a side wall of the reaction tube 203. The exhaust port 231a may be provided from the lower portion toward the upper portion of the reaction tube 203 along the side wall of the reaction tube 203, that is, along a wafer arrangement region (wafer arrangement area). The exhaust apparatus 246 such as a vacuum pump serving as a vacuum exhaust apparatus is connected to the exhaust pipe 231 through a pressure sensor 245 and an APC (Automatic Pressure Controller) valve 244. The pressure sensor 245 serves as a pressure detector (pressure detection structure) configured to detect a pressure (inner pressure) of the process chamber 201, and the APC valve 244 serves as a pressure regulator (pressure adjusting structure). Hereinafter, the vacuum pump may also be referred to as a "vacuum pump 246". According to the present embodiments, the exhaust pipe 231 serves as an exhaust flow path connecting the process chamber 201 with the vacuum pump 246 serving as the vacuum exhaust apparatus. With the vacuum pump 246 in operation, the APC valve 244 may be opened or closed to perform a vacuum exhaust operation for the process chamber 201 or stop the vacuum exhaust operation. In addition, with the vacuum pump 246 in operation, the inner pressure of the process chamber 201 may be adjusted by adjusting an opening degree of the APC valve 244 based on pressure information detected by the pressure sensor 245. An exhauster (which is an exhaust structure) is constituted mainly by the exhaust pipe 231, the APC valve 244 and the pressure sensor 245. The exhauster may further include the vacuum pump 246.

A seal cap 219 capable of airtightly sealing (closing) a lower end opening of the manifold 209 is provided under the manifold 209. An O-ring 220b serving as a seal and in contact with a lower end of the manifold 209 is provided on an upper surface of the seal cap 219. A rotator (which is a rotating structure) 267 configured to rotate a boat 217 described later and the wafers 200 is provided under the seal cap 219. The seal cap 219, the boat 217 and the wafers 200 are configured to be elevated and lowered in a vertical direction by a boat elevator 115. The boat elevator 115 serves as a transfer apparatus (transfer structure) capable of transferring (loading) the wafers 200 into the process chamber 201 and capable of transferring (unloading) the wafers 200 out of the process chamber 201.

A shutter 219s capable of airtightly sealing (closing) the lower end opening of the manifold 209 is provided under the manifold 209. The shutter 219s is configured to close the lower end opening of the manifold 209 when the seal cap 219 is lowered. An O-ring 220c serving as a seal is provided on an upper surface of the shutter 219s so as to be in contact with a lower end of the manifold 209. An opening and closing operation of the shutter 219s such as an elevation operation and a rotation operation is controlled by a shutter opener/closer (which is a shutter opening/closing structure) 115s.

The boat 217 serving as a substrate support (substrate retainer) is configured such that the wafers 200 (for example, 25 wafers to 200 wafers) are supported (or stacked) in the vertical direction in the boat 217 while the wafers 200 are horizontally oriented with their centers aligned with one another in a multistage manner. That is, the boat 217 is configured such that the wafers 200 are arranged in the vertical direction in the boat 217 while the wafers 200 are stacked in the vertical direction with a predetermined interval therebetween. For example, the boat 217 is made of a heat resistant material such as quartz and SiC. For example, a plurality of heat insulation plates 218 made of a heat resistant material such as quartz and SiC are supported at a lower portion of the boat 217 in a multistage manner.

A temperature sensor 263 serving as a temperature detector is installed in the reaction tube 203. A state of electric conduction to the heater 207 is adjusted based on temperature information detected by the temperature sensor 263 such that a desired temperature distribution of an inner temperature of the process chamber 201 can be obtained. The temperature sensor 263 is provided along the inner wall of the reaction tube 203.

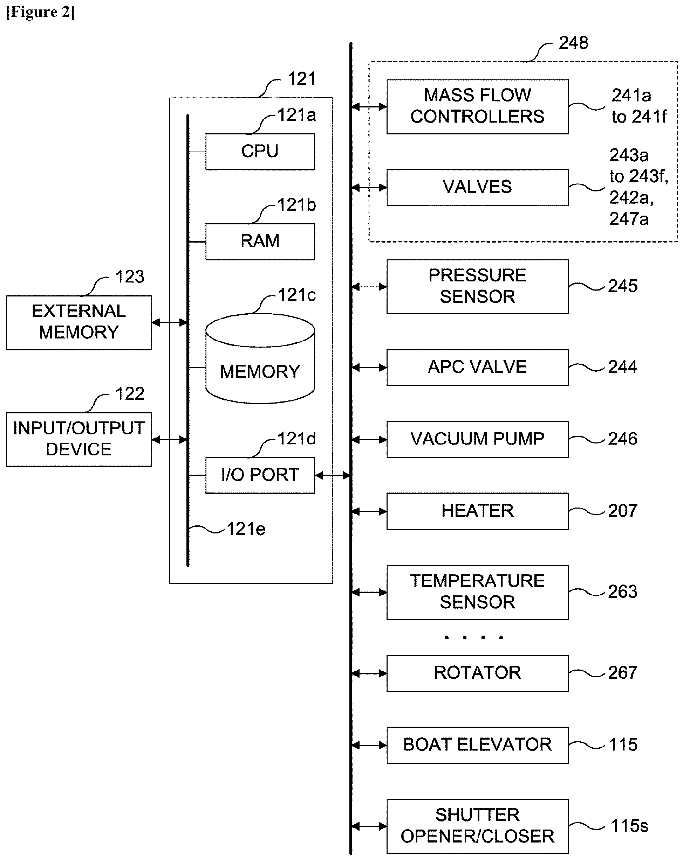

As shown in FIG. 2, a controller 121 serving as a control structure (control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d are configured to be capable of exchanging data with the CPU 121a through an internal bus 121e. For example, an input/output device 122 constituted by a component such as a touch panel is connected to the controller 121.

For example, the memory 121c is configured by a component such as a flash memory, a hard disk drive (HDD) and a solid state drive (SSD). For example, a control program configured to control an operation of the substrate processing apparatus 1 and a process recipe containing information on procedures and conditions of a substrate processing described later may be readably stored in the memory 121c. The process recipe is obtained by combining steps (procedures) of the substrate processing described later such that the controller 121 can execute the steps by the substrate processing apparatus 1 to acquire a predetermined result, and functions as a program. Hereinafter, the process recipe and the control program may be collectively or individually referred to as a "program" or a "program product". In addition, the process recipe may also be simply referred to as a "recipe". Thus, in the present specification, the term "program" may refer to the recipe alone, may refer to the control program alone or may refer to both of the recipe and the control program. The RAM 121b functions as a memory area where a program or data read by the CPU 121a is temporarily stored.

The I/O port 121d is connected to the components described above such as the MFCs 241a to 241f, the valves 243a, 242a, 247a and 243b to 243f, the pressure sensor 245, the APC valve 244, the vacuum pump 246, the temperature sensor 263, the heater 207, the rotator 267, the boat elevator 115 and the shutter opener/closer 115s.

The CPU 121a is configured to read the control program from the memory 121c and execute the control program read from the memory 121c. In addition, the CPU 121a is configured to read the recipe from the memory 121c, for example, in accordance with an operation command inputted from the input/output device 122. In accordance with contents of the recipe read from the memory 121c, the CPU 121a may be configured to be capable of controlling various operations such as flow rate adjusting operations for various substances (various gases) by the MFCs 241a to 241f, opening and closing operations of the valves 243a, 242a, 247a and 243b to 243f, an opening and closing operation of the APC valve 244, a pressure adjusting operation by the APC valve 244 based on the pressure sensor 245, a start and stop operation of the vacuum pump 246, a temperature adjusting operation by the heater 207 based on the temperature sensor 263, an operation of adjusting a rotation and a rotation speed of the boat 217 by the rotator 267, an elevating and lowering operation of the boat 217 by the boat elevator 115 and an opening and closing operation of the shutter 219s by the shutter opener/closer 115s.

The controller 121 may be embodied by installing the above-described program stored in an external memory 123 into the computer. For example, the external memory 123 may include a magnetic disk such as the HDD, an optical disk such as a CD, and a semiconductor memory such as a USB memory and the SSD. The memory 121c or the external memory 123 may be embodied by a non-transitory computer readable recording medium storing the program. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. Instead of the external memory 123, a communication interface such as the Internet and a dedicated line may be used for providing the program to the computer.

(2) Substrate Processing

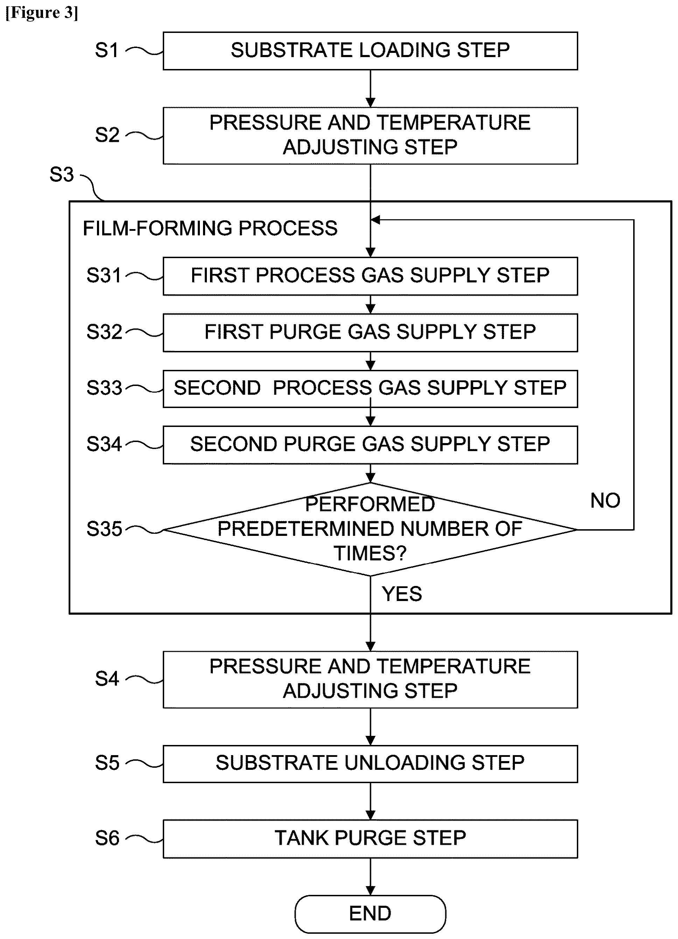

Hereinafter, an exemplary sequence of processing the wafer 200 serving as the substrate, (that is, an exemplary film forming sequence of forming a film on the wafer 200) by using the substrate processing apparatus 1 described above, which is a part of a manufacturing process of a semiconductor device, will be described mainly with reference to FIG. 3. The present embodiments will be described by way of an example in which a silicon substrate (silicon wafer) with a concave structure (recess) such as a trench and a hole formed on a surface thereof is used as the wafer 200. In the following description, operations of components constituting the substrate processing apparatus 1 can be controlled by the controller 121.

In a film forming sequence according to the present embodiments, the film is formed on the wafer 200 by performing a cycle a predetermined number of times (n times, n is an integer of 1 or more) (which corresponds to S35 in FIG. 3). For example, the cycle may include: a step A (corresponding to S31 in FIG. 3) of supplying the source gas, through the source gas supply line, into the process chamber 201 accommodating the wafer 200 with the concave structure formed on the surface thereof; and a step B (corresponding to S33 in FIG. 3) of supplying the reactive gas, through the reactive gas supply line, into the process chamber 201 accommodating the wafer 200.

In the present specification, for convenience of explanation, the film forming sequence mentioned above may be illustrated as follows. Similar notations will be used in explanations of modified examples and other embodiments described later.

$$(\text{Source gas} \times m \rightarrow \text{Reactive gas}) \times n$$

In addition, as shown in FIG. 3, when the step S31 and the step S33 are alternately performed n times (n is an integer of 1 or more), it is preferable to insert steps S32 and S34 of purging the process chamber 201 between the step S31 and the step S33. Hereinafter, the steps S31 and S32 may also be referred to as "step A (S31, S32)", and the steps S33 and S34 may also be referred to as "step B (S33, S34)".

In the present specification, the term "purge" refers to an operation of exhausting an atmosphere (inner atmosphere) of the process gas supplier or the process chamber 201 while supplying the inert gas into the process gas supplier or the process chamber 201. In addition, the term "exhaust" refers to an operation of exhausting the inner atmosphere of the process gas supplier or the process chamber 201 without supplying the inert gas into the process gas supplier or the process chamber 201. However, the term "exhaust" may also refer to an operation of exhausting the inner atmosphere of the process gas supplier or the process chamber 201 while supplying a minute amount of the inert gas, compared to the purge, into the process gas supplier or the process chamber 201.

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". Thus, in the present specification, "forming a predetermined layer (or a film) on a wafer" may refer to "forming a predetermined layer (or a film) directly on a surface of a wafer itself", or may refer to "forming a predetermined layer (or a film) on another layer (or another film) formed on a wafer". In the present specification, the terms "substrate" and "wafer" may be used as substantially the same meaning.

<Substrate Loading Step S1>

The plurality of wafers 200 are charged (loaded or transferred) into the boat 217 (wafer charging step). Thereafter, the shutter 219s is moved by the shutter opener/closer 115s to open the lower end opening of the manifold 209 (shutter opening step). Then, as shown in FIG. 1, the boat 217 is elevated by the boat elevator 115 and loaded (transferred) into the process chamber 201 (boat loading step). In such a state, the seal cap 219 airtightly seals (or closes) the lower end opening of the manifold 209 via the O-ring 220b.

<Pressure and Temperature Adjusting Step S2>

After the boat 217 is loaded, the vacuum pump 246 vacuum-exhausts (decompresses and exhausts) the inner atmosphere of the process chamber 201 (that is, a space in which the wafers 200 are present (accommodated)) such that the inner pressure of the process chamber 201 reaches and is maintained at a desired pressure (vacuum degree). In such an operation, the inner pressure of the process chamber 201 is measured by the pressure sensor 245, and the APC valve 244 is feedback-controlled based on the pressure information detected by the pressure sensor 245 (pressure adjusting step). In addition, the heater 207 heats the process chamber 201 such that a temperature of the wafer 200 in the process chamber 201 reaches and is maintained at a desired process temperature. In such an operation, the state of the electric conduction to the heater 207 is feedback-controlled based on the temperature information detected by the temperature sensor 263 such that a desired temperature distribution of the inner temperature of the process chamber 201 can be obtained (temperature adjusting step). In addition, a rotation of the wafer 200 is started by the rotator 267. The inner atmosphere of the process chamber 201 is continuously vacuum-exhausted and the wafer 200 is continuously heated and rotated until at least a processing of the wafer 200 is completed.

<Film Forming Process S3>

Then, the step A (S31, S32) and the step B (S33, S34) are sequentially performed in this order.

<Step A (S31, S32)>

<First Process Gas Supply Step S31>

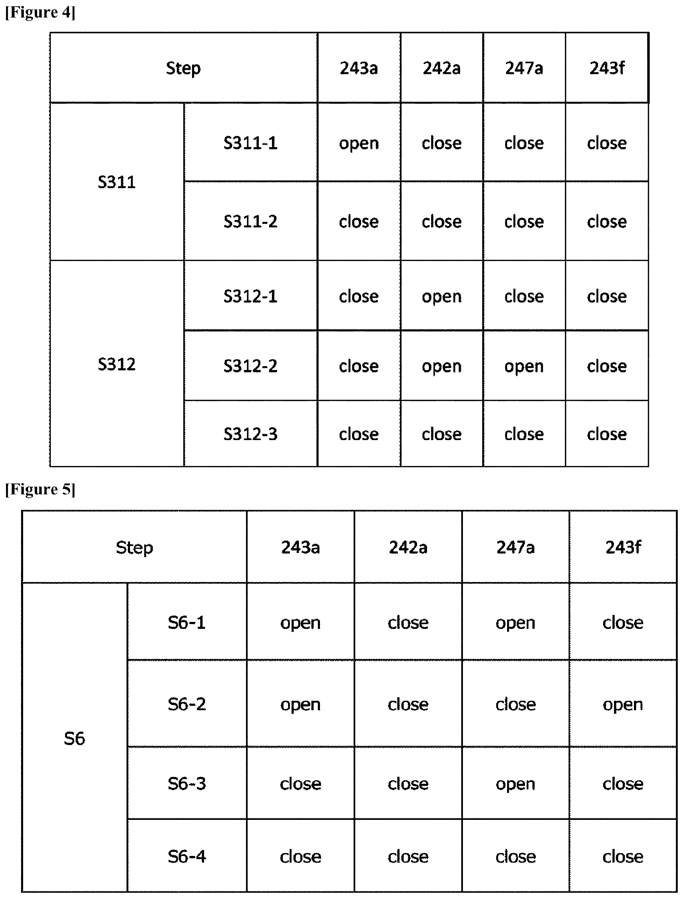

The step A may also be rephrased as (a) a step of supplying the source gas (which serves as the process gas) stored in the storage 240a in advance to the wafer (substrate) 200 disposed in the process chamber 201. Specifically, the first process gas supply step S31 may include: a step S311 (storage step) of storing the source gas (first process gas) in the storage 240a, and a step S312 (supply step: flash supply) of supplying the source gas into the process chamber 201. FIG. 4 is a diagram schematically illustrating a plurality of steps in the step S31 and states of the valves 243a, 242a, 247a and 243f in each step in the step S31. According to the present embodiments, the film containing a first element (such as silicon (Si)) is formed on the wafer 200, and the storage 240a is configured to store the source gas whose molecular structure contains two or more atoms of the first element as the process gas. According to the present embodiments, the heater 207 serving as the heating structure is configured to be capable of heating the process chamber 201 or the wafer 200 to a temperature equal to or higher than a thermal decomposition temperature of the process gas.

<S311>

As shown in FIG. 4, in a step S311-1, the valves 242a, 247a and 243f are closed ("close" in FIG. 4), and the valve 243a is open ("open" in FIG. 4). Thereby, the storage 240a is filled with the source gas. Subsequently, in a step S311-2, with a predetermined amount of the source gas has been filled in the storage 240a, the valves 243a, 242a, 247a and 243f are closed ("close"). Thereby, a state in which the storage 240a is filled with the source gas is maintained.

<S312>

As shown in FIG. 4, in a step S312-1, the valve 242a is open ("open"), and the valves 243a, 247a and 243f are closed ("close"). Then, the source gas whose pressure is high and filled in the storage 240a is supplied into the process chamber 201 at once. Thereby, the source gas is supplied to the wafer 200 at once (a flash supply of the source gas).
In the step S312-1, the valves 243c to 243e may be opened, and the inert gas may be supplied into the process chamber 201 through each of the nozzles 249a to 249c. In addition, in the step S312-1, for example, the APC valve 244 may be fully opened. As a result, it is possible to easily exhaust the gas in the process chamber 201 in a short time. Thereby, for example, it is possible to suppress an effect of a decomposition product derived from the source gas on the substrate processing.
In a step S312-2, the valves 243a and 243f are closed ("close"), and the valves 242a and 247a are open ("open"). The source gas is supplied from the storage 240a into the process chamber 201, and the source gas in the storage 240a is exhausted by the exhaust apparatus 246. In a step S312-3, the valves 242a, 243a, 247a and 243f are closed ("close") to prevent the source gas from being supplied into the storage 240a.
In other words, the controller 121 is configured to be capable of controlling the first opening/closing structure 243a, the second opening/closing structure 242a and the third opening/closing structure 247a to perform: (a1) a process of storing the process gas (that is, the source gas) in the storage 240a; (a2) a process of supplying the process gas from the storage 240a into the process chamber 201; and (b) a process of exhausting the gas including (or containing) the process gas from the storage 240a through the third opening/closing structure 247a. In addition, the controller 121 is configured to be capable of controlling the first opening/closing structure 243a, the second opening/closing structure 242a and the third opening/closing structure 247a such that (b) is started after (a2) is started and before (a2) is ended (completed).

For example, when a chlorosilane gas described later is used as the source gas, a silicon-containing layer containing chlorine (Cl) of a predetermined D containing chlorine may also be simply referred to as a "silicon-containing layer".

As the source gas, for example, a silane-based gas containing silicon (Si) serving as a main element (primary element) constituting the film to be formed on the wafer 200 may be used. As the silane-based gas, for example, a gas containing silicon and a halogen element, that is, a halosilane gas may be used. As the halogen element, for example, an element such as chlorine (Cl), fluorine (F), bromine (Br) and iodine (I) may be used. As the halosilane gas, for example, the chlorosilane gas containing silicon and chlorine may be used.

As the source gas, for example, the chlorosilane gas such as monochlorosilane ($SiH_3Cl$) gas, dichlorosilane ($SiH_2Cl_2$) gas, trichlorosilane ($SiHCl_3$) gas, tetrachlorosilane ($SiCl_4$) gas, hexachlorodisilane ($Si_2Cl_6$) gas and octachlorotrisilane ($Si_3Cl_8$) gas may be used. For example, one or more of the gases exemplified above as the chlorosilane gas may be used as the source gas.

As the source gas, for example, instead of or in addition to the chlorosilane gas, a fluorosilane gas such as tetrafluorosilane ($SiF_4$) gas and difluorosilane ($SiH_2F_2$) gas, a bromosilane gas such as tetrabromosilane ($SiBr_4$) gas and dibromosilane ($SiH_2Br_2$) gas, or an iodine silane gas such as tetraiodide silane ($SiI_4$) gas and diiodosilane ($SiH_2I_2$) gas may be used. For example, one or more of the gases exemplified above may be used as the source gas.

As the source gas, for example, instead of or in addition to the gases exemplified above, a gas containing silicon and an amino group, that is, an aminosilane gas may be used. The amino group refers to a monovalent functional group obtained by removing hydrogen (H) from ammonia, a primary amine or a secondary amine, and may be expressed as "$-NH_2$", "$-NHR$" or "$-NR_2$". In addition, "R" represents an alkyl group, and two "R"s of "$-NR_2$" may be the same or different from each other.

As the source gas, for example, the aminosilane gas such as tetrakis (dimethylamino) silane ($Si[N(CH_3)_2]_4$) gas, tris (dimethylamino) silane ($Si[N(CH_3)_2]_3H$) gas, bis (diethylamino) silane ($Si[N(C_2H_5)_2]_2H_2$) gas, bis (tertiarybutylamino) silane ($SiH_2[NH(C_4H_9)]_2$) gas and (diisopropylamino) silane ($SiH_3[N(C_3H_7)_2]$) gas may be used. For example, one or more of the gases exemplified above as the aminosilane gas may be used as the source gas.

As the inert gas, for example, nitrogen ($N_2$) gas or a rare gas such as argon (Ar) gas, helium (He) gas, neon (Ne) gas and xenon (Xe) gas may be used. For example, one or more of the gases exemplified above may be used as the inert gas. The same also applies to each step described later.

<First Purge Gas Supply Step S32>

Subsequently, after the first process gas supply step S31, the first purge gas supply step S32 is performed. In the first purge gas supply process S32, the valves 243c to 243e are opened, and the inert gas is supplied into the process chamber 201 through each of the nozzles 249a to 249c. Then, for example, with the APC valve 244 fully opened, the inner atmosphere of the process chamber 201 is vacuum-exhausted to remove a substance (such as the gas remaining in the process chamber 201) out of the process chamber 201.

<Step B (S33, S34)>

<Second Process Gas Supply Step S33>

Subsequently, after the step A is completed, the second process gas supply step S33 is performed. In the second process gas supply step S33, the reactive gas (second process gas) is supplied to the wafer 200 in the process chamber 201, that is, to the silicon-containing layer serving as the first layer formed on the wafer 200.

Specifically, the valve 243b is opened to supply the reactive gas into the gas supply pipe 232b. After a flow rate of the reactive gas is adjusted by the MFC 241b, the reactive gas whose flow rate is adjusted is supplied into the process chamber 201 through the nozzle 249b, and is exhausted through the exhaust port 231a. Thereby, the reactive gas is supplied to the wafer 200 (reactive gas supply step). In the present step, the valves 243c to 243e may be opened to supply the inert gas into the process chamber 201 through the nozzles 249a to 249c, respectively.

For example, by supplying a nitriding gas as the reactive gas to the wafer 200 under process conditions mentioned later, a layer obtained by nitriding the silicon-containing layer, that is, a silicon nitride layer (SiN layer) containing silicon and nitrogen (N) is formed as a second layer on the uppermost surface of the wafer 200, which serves as the base.

<Second Purge Gas Supply Step S34>

After the SiN layer serving as the second layer is formed, the valve 243b is closed to stop a supply of the nitriding gas into the process chamber 201. Then, by process procedures similar to those of the step A described above, the second purge gas supply step S34 is performed to remove a substance (such as the gas remaining in the process chamber 201) out of the process chamber 201 (purge step).

As the reactive gas, for example, a gas containing nitrogen (N) and hydrogen (H), that is, the nitriding gas (nitriding agent) may be used. The gas containing nitrogen and hydrogen serves as a nitrogen-containing gas, and also serves as a hydrogen-containing gas. It is preferable that the gas containing nitrogen and hydrogen contains a nitrogen - hydrogen bond (N - H bond). As the reactive gas, for example, a hydrogen nitride-based gas such as ammonia ($NH_3$) gas, diazene ($N_2H_2$) gas, hydrazine ($N_2H_4$) gas and $N_3H_8$ gas may be used. For example, one or more of the gases exemplified above may be used as the reactive gas.

As the reactive gas, for example, instead of the gas containing nitrogen and hydrogen exemplified above, a gas containing nitrogen (N), carbon (C) and hydrogen (H) may be used. For example, as the gas containing nitrogen, carbon and hydrogen, an amine-based gas or an organic hydrazine-based gas may be used. The gas containing nitrogen, carbon and hydrogen serves as a nitrogen-containing gas, a carbon-containing gas, a hydrogen-containing gas and a gas containing nitrogen and carbon. As the reactive gas, for example, an ethylamine-based gas such as monoethylamine ($C_2H_5NH_2$) gas, diethylamine (($C_2H_5)_2NH$) gas and triethylamine (($C_2H_5)_3N$) gas, a methylamine-based gas such as monomethylamine ($CH_3NH_2$) gas, dimethylamine (($CH_3)_2NH$) gas and trimethylamine (($CH_3)_3N$) gas, or an organic hydrazine-based gas such as monomethylhydrazine (($CH_3)HN_2H_2$) gas, dimethylhydrazine (($CH_3)_2N_2H_2$) gas, trimethyl-hydrazine (($CH_3)_2N_2(CH_3)H$) gas may be used. For example, one or more of the gases exemplified above may be used as the reactive gas.

<Performing Cycle Predetermined Number of Times: Step S35>

By performing the cycle including the step A and the step B described above a predetermined number of times (n times, wherein n is an integer of 1 or more), it is possible to form the film (for example, a silicon nitride film (SiN film)) on the surface of the wafer 200. For example, it is preferable that, in a second and subsequent executions (runs) of the cycle, the step A of filling the storage 240a with the source gas is performed in parallel with the step B of a previous execution (run) of the cycle. In addition, when the gas containing nitrogen, carbon and hydrogen is used as the reactive gas, for example, it is possible to form a silicon carbonitride layer (SiCN layer) as the second layer. In such a case, by performing the cycle mentioned above the predetermined number of times, it is possible to form the film (for example, a silicon carbonitride film (SiCN film)) on the surface of the wafer 200.

Examples of the process conditions for each of the steps mentioned above are shown below when, for example, the chlorosilane gas is used as the source gas and for example, the gas containing nitrogen and hydrogen is used as the reactive gas. In the present specification, a notation of a numerical range such as "from 1 Pa to 100 Pa" means that a lower limit and an upper limit are included in the numerical range. Therefore, for example, the numerical range "from 1 Pa to 100 Pa" means a range equal to or higher than 1 Pa and equal to or less than 100 Pa. The same also applies to other numerical ranges described in the present specification. In addition, in the present specification, the term "process temperature" may refer to the "temperature of the wafer 200", and the term "process pressure" may refer to the inner pressure of the process chamber 201.

For example, the process conditions of the step S312-1 are as follows:

A supply flow rate of the chlorosilane gas: from 1 sccm to 5,000 sccm, preferably from 100 sccm to 5,000 sccm;
A supply time (time duration) of supplying the chlorosilane gas: from 0.1 second to 20 seconds, preferably from 0.5 second to 5 seconds;
A supply flow rate of the inert gas: from 0 sccm to 30,000 sccm, preferably from 500 sccm to 20,000 sccm;
A process temperature: from 250 °C to 800 °C, preferably from 600 °C to 700 °C;
A process pressure: from 1 Pa to 2,666 Pa, preferably from 1 Pa to 1,333 Pa; and
A partial pressure of the chlorosilane gas: from 0.00005 Pa to 3,999 Pa, preferably from 0.06 Pa to 1,333 Pa.

For example, the process conditions of the step S33 are as follows:

A supply flow rate of the gas containing nitrogen and hydrogen: from 1 sccm to 20,000 sccm, preferably from 1,000 sccm to 10,000 sccm;
A supply time (time duration) of supplying the gas containing nitrogen and hydrogen: from 1 second to 120 seconds, preferably from 1 second to 60 seconds;
A supply flow rate of the inert gas: from 0 sccm to 20,000 sccm, preferably from 500 sccm to 10,000 sccm; and

A process pressure: from 1 Pa to 4,000 Pa, preferably from 1 Pa to 3,000 Pa.

Other process conditions thereof may be set to be the same (substantially the same) as those of the step A.

<Pressure and Temperature Adjusting Step S4>

After the film forming process S3 is completed, the inert gas serving as the purge gas is supplied into the process chamber 201 through each of the nozzles 249a to 249c, and then is exhausted through the exhaust port 231a. Thereby, the inner atmosphere of the process chamber 201 is purged with the purge gas (after-purge step). Thereafter, the inner atmosphere of the process chamber 201 is replaced with the inert gas (substitution by inert gas), and the inner pressure of the process chamber 201 is returned to the normal pressure (atmospheric pressure) (returning to atmospheric pressure step). The exhaust (exhaust operation) of the vacuum pump 246 is adjusted such that the inner pressure of the process chamber 201 (that is, the space in which the wafers 200 are present (accommodated)) reaches and is maintained at a desired pressure (atmospheric pressure). In addition, the heater 207 is adjusted such that the temperature of the wafer 200 in the process chamber 201 reaches and is maintained at a desired process temperature.

<Substrate Unloading Step S5>

Thereafter, the seal cap 219 is lowered by the boat elevator 115, and the boat 217 with the wafers 200 (which are processed) supported therein is unloaded (transferred) out of the reaction tube 203 (boat unloading step). After the boat 217 is unloaded, the lower end opening of the manifold 209 is sealed (closed) by the shutter 219s through the O-ring 220c (shutter closing step).

<Tank Purge Step S6>

A step S6 is a step of purging an atmosphere (inner atmosphere) of the storage 240a with the inert gas. FIG. 5 is a diagram schematically illustrating a plurality of steps (that is, a step S6-1, a step S6-2, a step S6-3 and a step S6-4) in the step S6 and states of the valves 243a, 242a, 247a and 243f in each step in the step S6. That is, the step S6 includes the step S6-1 to the step S6-4. In addition, the step S6 may be performed at least partially simultaneously with at least one among the pressure and temperature adjusting step S4 and the substrate unloading step S5.
In the step S6-1, the valves 243a and 247a are open, and the valves 242a and 243f are closed. Thereby, it is possible to vacuum-exhaust the check valve 245a and its downstream components. Since the source gas at an upstream side of the valve 243a can be removed before the step S6-2, it is possible to prevent the source gas from entering an upstream side of the valve 243f.
In the step S6-2, the valves 243a and 243f are open, and the valves 242a and 247a are closed. Thereby, it is possible to supply the purge gas into the storage 240a. The steps S6-1 and S6-2 are repeatedly performed a predetermined number of times. According to the present embodiments, for example, the predetermined number of times is within a range from one time to 20 times. To prevent the source gas from remaining between the valve 243f and the valve 243a, it is preferable to complete an execution (of repeatedly performing the steps S6-1 and S6-2) with the step S6-1 as the final step.
In the step S6-3, the valve 247a is open, and the valves 242a, 243a and 243f are closed. Thereby, it is possible to vacuum-exhaust the valve 243a and its downstream components. In the step S6-4, the valves 243a, 242a, 247a and 243f are closed. Then, the step S6 is completed.
In other words, the controller 121 is configured to be capable of controlling the first opening/closing structure 243a, the second opening/closing structure 242a, the third opening/closing structure 247a and the fourth opening/closing structure 243f to perform: (a1) the process of storing the process gas in the storage 240a; (a2) the process of supplying the process gas from the storage 240a into the process chamber 201; (c1) a process of supplying the purge gas into the storage 240a; and (c2) a process of exhausting a gas including (or containing) the purge gas from the storage 240a through the third opening/closing structure 247a.

<Modified Examples>

Hereinafter, several modified examples will be described.

<First Modified Example>

In the step S312-1, the valves 243a and 242a may be simultaneously opened while the valves 247a and 243f are closed. According to the first modified example, it is possible to supply the first process gas (source gas) into the process chamber 201 simultaneously from the storage 240a and the vaporizer 232v.

<Second Modified Example>

After the step S312-1, a step (in which the valves 247a and 243f are closed) may be added. After such a step, the step S312-2 may be performed. According to a second modified example, after the flash supply of the source gas, it is possible to supply the first process gas (source gas) into the process chamber 201 simultaneously from the storage 240a and the vaporizer 232v. In other words, the controller 121 is configured to be capable of controlling the first opening/closing structure 243a, the second opening/closing structure 242a and the third opening/closing structure 247a to further perform: (a3) a process of supplying the process gas from the first supply source 232v into the process chamber 201 after (a2) (that is, the process of supplying the process gas from the storage 240a into the process chamber 201). Alternatively, the controller 121 is configured to be capable of controlling the first opening/closing structure 243a, the second opening/closing structure 242a and the third opening/closing structure 247a such that (a3) is started simultaneously with (a2).

<Third Modified Example>

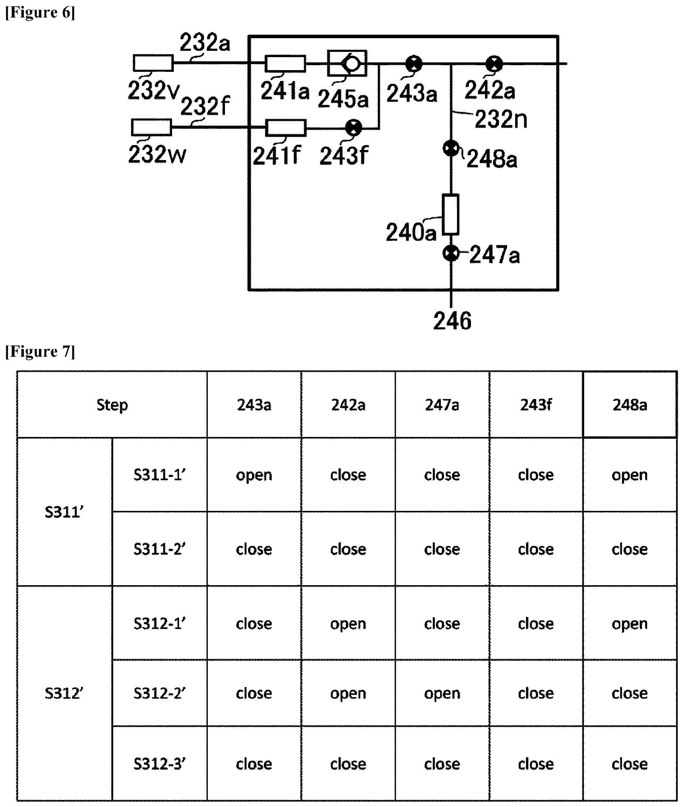

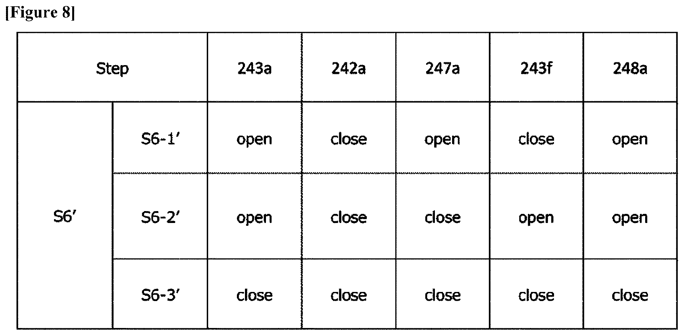

FIG. 6 is a diagram schematically illustrating a source gas supplier according to a third modified example. FIG. 7 is a diagram schematically illustrating a plurality of steps in a step S31' according to the third modified example and states of the valves 243a, 242a, 247a and 243f and a valve 248a in each step in the step S31'. FIG. 8 is a diagram schematically illustrating a plurality of steps (that is, a step S6-1', a step S6-2' and a step S6-3') in a step S6' according to the third modified example and states of the valves 243a, 242a, 247a, 243f and 248a in each step in the step S6'.
A source gas supplier according to the third modified example shown in FIG. 6 is different from the source gas supplier shown in FIG. 1 in that the valve 248a serving as a fifth opening/closing structure is provided at the gas supply pipe 232n, between the gas supply pipe 232a and the storage 240a. Hereinafter, the valve 248a may also be referred to as the "fifth opening/closing structure 248a". The other components of the source gas supplier according to the third modified example shown in FIG. 6 are similar to the other components of the source gas supplier shown in FIG. 1. That is, substantially the same components shown in FIG. 6 as those of the source gas supplier shown in FIG. 1 will be denoted by like reference numerals, and detailed descriptions thereof will be omitted.
In addition, it is preferable that, a configuration of the third modified example does not include any flow path whose one end is connected to the storage 240a and whose the other end is connected to the first flow path 232a at a location between the second opening/closing structure 242a and the process chamber 201 and any flow path whose one end is connected to the storage 240a and whose the other end is connected to the process chamber 201 as shown in FIG. 1 or FIG. 6. Thereby, it is possible to more easily improve a flexibility of a layout of a gas supply system 248 shown in FIG. 3.
As shown in FIG. 7, in the first process gas supply step S31', in particular, in a step S311-1', the valves 242a, 247a and 243f are closed, and the valves 243a and 248a are open. Thereby, the source gas is supplied into the gas supply pipe 232a. After a flow rate of the source gas is adjusted by the MFC 241a, the source gas whose flow rate is adjusted is supplied into the storage 240a through the check valve 245a. Thereby, the storage 240a is filled with the source gas. Subsequently, in a step S311-2', with a predetermined amount of the source gas has been filled in the storage 240a, the valves 243a, 242a, 247a, 243f and 248a are closed. Thereby, the state in which the storage 240a is filled with the source gas is maintained.
As shown in FIG. 7, in a step S312-1', the valves 242a and 248a are opened, and the valves 243a, 247a and 243f are closed. Then, the source gas whose pressure is high and filled in the storage 240a is supplied into the process chamber 201 at once. Thereby, the source gas is supplied to the wafer 200 at once (the flash supply of the source gas). In the step S312-1', the valves 243c to 243e may be opened, and the inert gas may be supplied into the process chamber 201 through each of the nozzles 249a to 249c. In addition, in the step S312-1', it is preferable that the APC valve 244 is fully opened.
In a step S312-2', the valves 243f and 248a are closed, and the valves 243a, 242a, and 247a are open. As a result, the source gas is vaporized by the vaporizer 232v. Then, after the flow rate of the source gas is adjusted by the MFC 241a, the source gas whose flow rate is adjusted is supplied into the process chamber 201 through the check valve 245a. Meanwhile, the source gas in the storage 240a is exhausted by the exhaust apparatus 246. In a step S312-3', the valves 242a, 243a, 247a, 243f and 248a are closed such that a subsequent step, that is, the step S312 can be performed.
In other words, the controller 121 is configured to be capable of controlling the first opening/closing structure 243a, the second opening/closing structure 242a, the third opening/closing structure 247a and the fifth opening/closing structure 248a to perform: (a1) the process of storing the process gas in the storage 240a; (a2) the process of supplying the process gas from the storage 240a into the process chamber 201; and (a3) the process of supplying the process gas from the first supply source 232v into the process chamber 201, wherein (a2) and (a3) are performed non-simultaneously.
Subsequently, the tank purge step S6' according to the third modified example will be described with reference to FIG. 8.
The step S6' is a step of purging the atmosphere (inner atmosphere) of the storage 240a with the inert gas. FIG. 8 is a diagram schematically illustrating the plurality of steps in the step S6' and the states of the valves 243a, 242a, 247a, 243f and 248a in each step in the step S6'. That is, the step S6' includes the step S6-1' to the step S6-3'.

In the step S6-1', the valves 243a, 247a and 248a are open, and the valves 242a and 243f are closed. Thereby, it is possible to vacuum-exhaust the check valve 245a and its downstream components. Since the source gas at the upstream side of the valve 243a can be removed before the valve 243f is opened in the step S6-2', it is possible to prevent the source gas from entering the upstream side of the valve 243f.

In the step S6-2', the valves 243a, 243f and 248a are open, and the valves 242a and 247a are closed. Thereby, it is possible to supply the purge gas into the storage 240a. The step S6-2' is repeatedly performed a predetermined number of times. According to the present embodiments, for example, the predetermined number of times is within a range from one time to 20 times. To prevent the source gas from remaining between the valve 243f and the valve 243a, it is preferable to complete an execution (of repeatedly performing the step S6-2') with the step S6-1' as the final step.

In the step S6-3', the valves 243a, 242a, 247a, 243f and 248a are closed Then, the step S6' is completed.

(3) Effects According to Present Disclosure

According to the present embodiments, it is possible to obtain one or more of the following effects.

(A) The substrate processing apparatus 1 may include: the process chamber 201; the first flow path 232a one end (first end) of which is connected to the first supply source 232v configured to supply the process gas and the other end (second end) of which is connected to the process chamber 201; the first opening/closing structure 243a provided at the first flow path 232a; the second opening/closing structure 242a provided at the first flow path 232a between the first opening/closing structure 243a and the process chamber 201; the second flow path 232n one end (first end) of which is connected to the location in the first flow path 232a between the first opening/closing structure 243a and the second opening/closing structure 242a and the other end (second end) of which is connected to the exhaust apparatus 246; the storage 240a provided at the second flow path 232n; and the third opening/closing structure 247a provided at the second flow path 232n between the storage 240a and the exhaust apparatus 246.

By supplying the process gas stored in the storage 240a to the process chamber 201 and the substrate 200, it is possible to supply a large flow rate of the process gas into the process chamber 201. As a result, a partial pressure of the process gas in the process chamber 201 can be increased. Thereby, it is possible to easily deliver the process gas into a deep location (portion) of a pattern on the substrate. Thereby, it is possible to uniformly process an inside (inner portion) of the pattern. In such a case, the shorter the pipe (piping) between the final valve (that is, a valve configured to control a start and a stop of a supply of the gas) and the process chamber 201, or the fewer bends in the pipe, the smaller a pressure loss. Thereby, it is possible to easily supply the large flow rate of the process gas into the process chamber 201. In addition, the larger the capacity of the storage 240a, the larger the amount of the process gas capable of being stored therein. Thereby, it is possible to easily supply the large flow rate of the process gas into the process chamber 201. According to the technique of the present disclosure, a footprint of the substrate processing apparatus 1 may impose limitations on a size of the substrate processing apparatus 1 and a gas supply system (such as the gas supply system 248) thereof, as well as a layout of each component. Therefore, due to layout constraints, the pipe between the final valve and the process chamber 201 may be lengthened or additional bends may be added, a volume of the storage 240a may be limited, or a trade-off may be imposed between them.

According to the technique of the present disclosure, the storage 240a can be located away from the first flow path 232a between the vaporizer 232v (serving as the first supply source) and the process chamber 201. Thereby, it is possible to improve the flexibility of the layout of the gas supply system 248. As a result, for example, the pipe between the final valve (for example, a valve such as the valves 242a, 243b, 243c, 243d and 243e) and the process chamber 201 can be shortened, the bends in pipe can be reduced, and the storage 240a with a larger capacity can be used. In other words, according to the technique of the present disclosure, it is possible to easily supply the large flow rate of the process gas (source gas) into the process chamber 201.

In addition, by providing the second flow path 232n connecting the storage 240a and the exhaust apparatus 246 without passing through the process chamber 201, it is possible to prevent (or suppress) the process gas from remaining in the storage 240a. As a result, it is possible to prevent (or suppress) particles from being generated in the storage 240a and from moving into the process chamber 201.

(B) The controller 121 of the substrate processing apparatus 1 is configured to be capable of controlling the first opening/closing structure 243a, the second opening/closing structure 242a and the third opening/closing structure 247a to perform: (a1) the process of storing the process gas in the storage 240a; (a2) the process of supplying the process gas from the storage 240a into the process chamber 201; and (b) the process of exhausting the gas including (or containing) the process gas from the storage 240a through the third opening/closing structure 247a. Thus, various films of different composition ratios, qualities and thicknesses can be formed in a reliably reproducible manner by using the single substrate processing apparatus 1. In addition, since a burden on an operating personnel can be reduced, various processes can be started quickly while avoiding an error in operating the substrate processing apparatus 1.

(C) When the process gas is supplied from the storage 240a, a larger amount of the gas is likely to be supplied into the process chamber 201 per unit time than an amount of the gas exhausted from the process chamber 201. As a result, as time has elapsed from a start of (a2), a large amount of a decomposition product (that is, a substance generated by decomposing the process gas) or large amount of a reaction by-product (a substance generated by a reaction between the process gas and a substance on the substrate 200) is likely to remain in the process chamber 201. Thereby, when the process gas is supplied for a long period of time, the decomposition product and the reaction by-product may easily form the film on an opening location (opening side) of the pattern relative to the deep location of the pattern. In such a case, it is difficult to uniformly process the inside of the pattern.

After the start of (a2) and before a start of (b), the partial pressure of the process gas can be increased while the amount of the decomposition product or the amount of the reaction by-product in the process chamber 201 is low. Then, after the start of (b), the process gas in the storage 240a is less likely to be supplied into the process chamber 201. Thereby, it is possible to prevent (or suppress) the decomposition product (or the reaction by-product) from being generated. As a result, it is possible to easily and uniformly process the inside of the pattern.

(D) The controller 121 according to at least one among the first to third modified examples is configured to be capable of controlling the first opening/closing structure 243a, the second opening/closing structure 242a and the third opening/closing structure 247a to further perform (a3) the process of supplying the process gas from the first supply source 232v into the process chamber 201. With such a configuration, in addition to the process gas supplied from the storage 240a, it is possible to supply the process gas into the process chamber 201 from the first supply source 232v. As a result, it is possible to more easily supply the large flow rate of the process gas into the process chamber 201.

(E) The controller 121 according to the first modified example is configured to be capable of controlling the first opening/closing structure 243a, the second opening/closing structure 242a and the third opening/closing structure 247a such that (a3) is started simultaneously with (a2). As a result, it is possible to further increase a maximum partial pressure of the process gas in the process chamber 201. Thereby, it is possible to uniformly process the inside of the pattern.

(F) The controller 121 according to the second modified example is configured to be capable of controlling the first opening/closing structure 243a, the second opening/closing structure 242a and the third opening/closing structure 247a such that (a3) is started after (a2) is started. Thus, as time has elapsed from the start of (a2), a pressure difference between the storage 240a and the process chamber 201 decreases. Thereby, the flow rate of the process gas supplied from the storage 240a to the process chamber 201 decreases. As a result, a sufficient amount of the process gas may not be supplied to an entire surface of the substrate 200. By starting (a3) after (a2), as in the second modified example, since a period (time duration) during which the flow rate of the process gas is low can be reduced, it is possible to easily ensure the sufficient amount of the process gas for the entire surface of the substrate 200.

(G) The substrate processing apparatus 1 may further include: the third flow path 232f one end (first end) of which is connected to the second supply source 232w configured to supply the purge gas and the other end (second end) of which is connected to the first flow path 232a; and the fourth opening/closing structure 243f provided at the third flow path 232f. Thereby, it is possible to supply the purge gas into the storage 240a and to exhaust the purge gas from the storage 240a through a route (flow path) without passing through the process chamber 201. As a result, it is possible to further prevent (or suppress) the particles from being generated in the storage 240a and from moving into the process chamber 201.

(H) The controller 121 is configured to be capable of controlling the first opening/closing structure 243a, the second opening/closing structure 242a, the third opening/closing structure 247a and the fourth opening/closing structure 243f to perform: (a1) the process of storing the process gas in the storage 240a; (a2) the process of supplying the process gas from the storage 240a into the process chamber 201; (c1) the process of supplying the purge gas into the storage 240a; and (c2) the process of exhausting the gas including (or containing) the purge gas from the storage 240a through the third opening/closing structure 247a. Thus, various films of different composition ratios, qualities and thicknesses can be formed in a reliably reproducible manner by using the single substrate processing apparatus 1. In addition, since the burden on the operating personnel can be reduced, various processes can be started quickly while avoiding an error in operating the substrate processing apparatus 1.

(I) As in the embodiments, the first modified example and the second modified example, it is preferable that no other opening/closing structures (valves) are provided at the first flow path 232a between the first opening/closing structure 243a and the second opening/closing structure 242a, and at the second flow path 232n between the first flow path 232a and the storage 240a. Thereby, it is possible to reduce the pressure loss between the storage 240a and the process chamber 201. As a result, it is possible to uniformly process the inside of the pattern formed on the surface of the substrate 200.

(J) The substrate processing apparatus 1 according to the third modified example may further include the fifth opening/closing structure 248a provided at the second flow path 232n, between the first flow path 232a and the storage 240a. Thereby, in addition to a supply of the process gas from the storage 240a alone and a supply of the process gas from both of the storage 240a and the first supply source 232v, it is possible to supply the process gas from the first supply source 232v alone. Therefore, the substrate processing apparatus 1 can implement even more gas supply patterns.

(K) The controller 121 of the substrate processing apparatus 1 according to the third modified example is configured to be capable of controlling the first opening/closing structure 243a, the second opening/closing structure 242a, the third opening/closing structure 247a and the fifth opening/closing structure 248a to perform: (a1) the process of storing the process gas in the storage 240a; (a2) the process of supplying the process gas from the storage 240a into the process chamber 201; and (a3) the process of supplying the process gas from the first supply source 232v into the process chamber 201, wherein (a2) and (a3) are performed non-simultaneously. Thus, various films of different composition ratios, qualities and thicknesses can be formed in a reliably reproducible manner by using the single substrate processing apparatus 1. In addition, since the burden on the operating personnel can be reduced, various processes can be started quickly while avoiding an error in operating the substrate processing apparatus 1.

(L) The film containing the first element is formed on the substrate 200, and the storage 240a is configured to store the source gas (for example, a gas such as the $Si_2Cl_6$ gas and the $Si_3Cl_8$ gas) whose molecular structure contains two or more atoms of the first element as the process gas. In such a case, when the amount of the process gas supplied to the wafer 200 is insufficient, a difference in the progress of the process between a location on the wafer 200 where the gas can easily reach and a location on the wafer 200 where the gas is difficult to reach is likely to become large. For example, the difference is likely to become large between an edge of the wafer 200 and the center of the wafer 200, or between the opening location of the pattern and the deep location of the pattern formed on the wafer 200. However, according to the technique of the present disclosure, it is possible to easily supply the large flow rate of the process gas from the storage 240a into the process chamber 201. As a result, even in such case, it is possible to easily and uniformly process the wafer 200.

(M) The storage 240a is configured to store therein, as the process gas, the source gas obtained by phase-changing the liquid or solid using the vaporizer 232v. In such a case, the process gas may liquefy or solidify within the storage 240a, generating the particles. According to the technique of the present disclosure, the storage 240a can be provided (disposed) between the second supply source 232w and the exhaust apparatus 246 during a step such as the tank purge step S6. Thereby, it is possible to efficiently purge an inside (inner portion) of the storage 240a. Therefore, the particles can be prevented from being attached to the wafer 200 even in such case.

(N) The heater 207 heats the process chamber 201 or the substrate 200 to a temperature equal to or higher than the thermal decomposition temperature of the source gas serving as the process gas. In such a case, by using the technique of the present disclosure, it is possible to supply a large flow rate of the source gas to the wafer 200 in a short time after the supply of the source gas is started. As a result, it is possible to reduce (suppress) the effect of the decomposition product derived from the source gas on the substrate processing.

The invention may be summarized as follows: To easily supply a large flow rate of a process gas into a process chamber, a technique includes: a first flow path one end of which is connected to a first supply source configured to supply a process gas and the other end of which is connected to a process chamber in which a substrate is processed; a first opening/closing structure provided at the first flow path; a second opening/closing structure provided at the first flow path between the first opening/closing structure and the process chamber; a second flow path one end of which is connected to the first flow path between the first opening/closing structure and the second opening/closing structure and the other end of which is connected to an exhaust apparatus; a storage provided at the second flow path; and a third opening/closing structure provided at the second flow path between the storage and the exhaust apparatus.

For example, the embodiments mentioned above are described by way of an example in which the chlorosilane gas is used as the source gas. However, the technique of the present disclosure is not limited thereto. For example, the technique of the present disclosure may be applied when forming a film containing a metal element on the substrate by using a source gas containing a metal element such as aluminum (Al), titanium (Ti), hafnium (Hf), zirconium (Zr), tantalum (Ta), molybdenum (Mo) and tungsten (W) and using the film forming sequence mentioned above. For example, the film may include one or more among an aluminum nitride film (AlN film), a titanium nitride film (TiN film), a hafnium nitride film (HfN film), a zirconium nitride film (ZrN film), a tantalum nitride film (TaN film), a molybdenum nitride film (MoN film), a tungsten nitride film (WN film), an aluminum oxide film (AlO film), a titanium oxide film (TiO film), a hafnium oxide film (HfO film), a zirconium oxide film (ZrO film), a tantalum oxide film (TaO film), a molybdenum oxide film (MoO film), a tungsten oxide film (WO film), a titanium oxynitride film (TiON film), a titanium aluminum carbonitride film (TiAlCN film), a titanium aluminum carbide film (TiAlC film) and a titanium carbonitride film (TiCN film). Even in such a case, it is possible to obtain at least a part of the effects of the embodiments mentioned above.

For example, the embodiments mentioned above are described by way of an example in which the gas containing nitrogen and hydrogen is used as the reactive gas. However, the technique of the present disclosure is not limited thereto. For example, as the reactive gas, a carbon (C)-containing gas such as ethylene ($C_2H_4$) gas, acetylene ($C_2H_2$) gas and propylene ($C_3H_6$) gas, a boron (B)-containing gas such as diborane ($B_2H_6$) gas and trichloroborane ($BCl_3$) gas, or an oxygen (O)-containing gas such as oxygen ($O_2$) gas, ozone ($O_3$) gas, plasma-excited $O_2$ gas ($O_2^*$), $O_2$ gas + hydrogen ($H_2$) gas, water vapor ($H_2O$ gas), hydrogen peroxide ($H_2O_2$) gas, nitrous oxide ($N_2O$) gas, nitric oxide (NO) gas, nitrogen dioxide ($NO_2$) gas, carbon monoxide (CO) gas and carbon dioxide ($CO_2$) gas may be used. In the present specification, a simultaneous mention of two gases (such as "$O_2$ gas + $H_2$ gas") refers to a gaseous mixture of the two gases, (for example, a gaseous mixture of the $O_2$ gas and the $H_2$ gas. When supplying the gaseous mixture of the two gases, the two gases may be mixed (pre-mixed) in a supply pipe and then supplied into the process chamber 201. Alternatively, the two gases may be supplied separately into the process chamber 201 through different supply pipes and mixed (post-mixed) in the process chamber 201. One or more of the gases exemplified above may be used as the reactive gas. Even in such a case, it is possible to obtain at least a part of the effects of the embodiments mentioned above.

For example, the embodiments mentioned above are described by way of an example in which the SiN film or the SiCN film is formed on the wafer 200 in the substrate processing. However, the technique of the present disclosure is not limited thereto. For example, in addition to or instead of the SiN film or the SiCN film, the technique of the present disclosure may be applied when forming a film containing silicon, such as a silicon oxynitride film (SiON film), a silicon oxycarbide film (SiOC film), a silicon oxycarbonitride film (SiOCN film), a silicon borocarbonitride film (SiBCN film), a silicon boronitride film (SiBN film) and a silicon oxide film (SiO film). Even in such a case, it is possible to obtain at least a part of the effects of the embodiments mentioned above.

It is preferable that recipes used in each process are prepared individually in accordance with contents of each process and stored in the memory 121c via an electric communication line or the external memory 123. When starting each process, it is preferable that the CPU 121a selects an appropriate recipe among the recipes stored in the memory 121c in accordance with the contents of each process. Thus, various films of different composition ratios, qualities and thicknesses can be formed in a reliably reproducible manner by using the single substrate processing apparatus 1. In addition, since the burden on the operating personnel can be reduced, various processes can be started quickly while avoiding an error in operating the substrate processing apparatus 1.

The recipe described above is not limited to creating a new recipe. For example, the recipe may be prepared by changing an existing recipe installed in the substrate processing apparatus 1 in advance. When changing the existing recipe to a new recipe, the new recipe may be installed in the substrate processing apparatus 1 via the electric communication line or a recording medium in which the new recipe is stored. Further, the existing recipe already stored in the substrate processing apparatus 1 may be directly changed to the new recipe by operating the input/output device 122 of the substrate processing apparatus 1.

For example, the embodiments mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of processing one or several substrates at once is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The process procedures and the process conditions of each process using the substrate processing apparatuses mentioned above may be substantially the same as those of the embodiments or the modified examples mentioned above. Even in such a case, it is possible to obtain substantially the same effects as in the embodiments or the modified examples mentioned above. In addition, the embodiments and the modified examples mentioned above may be appropriately combined. The process procedures and the process conditions of each combination thereof may be substantially the same as those of the embodiments mentioned above.

### [Description of Reference Numerals]

| | | | |
|---|---|---|---|
| 1: | substrate processing apparatus, | 201: | process chamber, |
| 232v: | first supply source, | 232a: | first flow path, |
| 243a: | first opening/closing structure, | 242a: | second opening/closing structure, |
| 247a: | third opening/closing structure, | 232n: | second flow path, |
| 240a: | storage, | 246: | exhaust apparatus. |

### Claims

1.  A substrate processing apparatus comprising:

    a first flow path one end of which is connected to a first supply source configured to supply a process gas and the other end of which is connected to a process chamber in which a substrate is processed;
    a first opening/closing structure provided at the first flow path;

a second opening/closing structure provided at the first flow path between the first opening/closing structure and the process chamber;

a second flow path one end of which is connected to a location in the first flow path between the first opening/closing structure and the second opening/closing structure and the other end of which is connected to an exhaust apparatus;

a storage provided at the second flow path; and

a third opening/closing structure provided at the second flow path between the storage and the exhaust apparatus.

2. The substrate processing apparatus of claim 1, further comprising

a controller configured to be capable of controlling the first opening/closing structure, the second opening/closing structure and the third opening/closing structure to perform:

(a1) storing the process gas in the storage;

(a2) supplying the process gas from the storage into the process chamber; and

(b) exhausting a gas containing the process gas from the storage through the third opening/closing structure.

3. The substrate processing apparatus of claim 2, wherein the controller is further configured to be capable of controlling the first opening/closing structure, the second opening/closing structure and the third opening/closing structure such that (b) is started after (a2) is started and before (a2) is completed.

4. The substrate processing apparatus of claim 2 and/or 3, wherein the controller is further configured to be capable of controlling the first opening/closing structure, the second opening/closing structure and the third opening/closing structure to further perform

(a3) supplying the process gas from the first supply source into the process chamber.

5. The substrate processing apparatus of claim 4, wherein the controller is further configured to be capable of controlling the first opening/closing structure, the second opening/closing structure and the third opening/closing structure such that (a3) is started simultaneously with (a2) or such that (a3) is started after (a2) is started.

6. The substrate processing apparatus of any one or more of claims 1 to 5, further comprising:

a third flow path one end of which is connected to a second supply source configured to supply a purge gas and the other end of which is connected to the first flow path; and

a fourth opening/closing structure provided at the third flow path.

7. The substrate processing apparatus of claim 6, further comprising

a controller configured to be capable of controlling the first opening/closing structure, the second opening/closing structure, the third opening/closing structure and the fourth opening/closing structure to perform:

(a1) storing the process gas in the storage;

(a2) supplying the process gas from the storage into the process chamber;

(c1) supplying the purge gas into the storage; and

(c2) exhausting a gas containing the purge gas from the storage through the third opening/closing structure.

8. The substrate processing apparatus of any one or more of claims 1 to 7, wherein no other opening/closing structures are provided at the first flow path between the first opening/closing structure and the second opening/closing structure, and at the second flow path between the first flow path and the storage.

9. The substrate processing apparatus of any one or more of claims 1 to 8, further comprising

a fifth opening/closing structure provided at the second flow path between the first flow path and the storage.

10. The substrate processing apparatus of claim 9, further comprising

a controller configured to be capable of controlling the first opening/closing structure, the second opening/closing structure, the third opening/closing structure and the fifth opening/closing structure to perform:

(a1) storing the process gas in the storage;

(a2) supplying the process gas from the storage into the process chamber;

(a3) supplying the process gas from the first supply source into the process chamber,
wherein (a2) and (a3) are performed non-simultaneously.

11. The substrate processing apparatus of any one or more of claims 1 to 10, wherein the storage is configured to store the process gas whose molecular structure contains two or more atoms of a first element constituting a film to be formed on the substrate.

12. The substrate processing apparatus of any one or more of claims 1 to 11, wherein no flow path provided at the substrate processing apparatus satisfies both of: (i) one end of which is connected to the storage and (ii) the other end of which is connected to a location in the first flow path between the second opening/closing structure and the process chamber, and
no flow path provided at the substrate processing apparatus satisfies both of: (i) one end of which is connected to the storage and (ii) the other end of which is connected to the process chamber.

13. A substrate processing method using a substrate processing apparatus comprising:

a first flow path one end of which is connected to a first supply source configured to supply a process gas and the other end of which is connected to a process chamber;
a first opening/closing structure provided at the first flow path; a second opening/closing structure provided at the first flow path between the first opening/closing structure and the process chamber;
a second flow path one end of which is connected to a location in the first flow path between the first opening/closing structure and the second opening/closing structure and the other end of which is connected to an exhaust apparatus;
a storage provided at the second flow path; and
a third opening/closing structure provided at the second flow path between the storage and the exhaust apparatus,
wherein the substrate processing method comprises

(a) supplying the process gas stored in the storage in advance to a substrate disposed in the process chamber.

14. A method of manufacturing a semiconductor device, comprising
the method of claim 13.

15. A program related to a substrate processing apparatus comprising:

a first flow path one end of which is connected to a first supply source configured to supply a process gas and the other end whose is connected to a process chamber;
a first opening/closing structure provided at the first flow path; a second opening/closing structure provided at the first flow path between the first opening/closing structure and the process chamber;
a second flow path one end whose is connected to a location in the first flow path between the first opening/closing structure and the second opening/closing structure and the other end whose is connected to an exhaust apparatus;
a storage provided at the second flow path; and a third opening/closing structure provided at the second flow path between the storage and the exhaust apparatus,
wherein the program causes the substrate processing apparatus, by a computer, to perform:

(a) supplying the process gas stored in the storage in advance to a substrate disposed in the process chamber.

[Figure 1]

[Figure 2]

[Figure 3]

S1 — SUBSTRATE LOADING STEP

S2 — PRESSURE AND TEMPERATURE ADJUSTING STEP

S3

FILM-FORMING PROCESS

S31 — FIRST PROCESS GAS SUPPLY STEP

S32 — FIRST PURGE GAS SUPPLY STEP

S33 — SECOND PROCESS GAS SUPPLY STEP

S34 — SECOND PURGE GAS SUPPLY STEP

S35 — PERFORMED PREDETERMINED NUMBER OF TIMES?   NO

YES

S4 — PRESSURE AND TEMPERATURE ADJUSTING STEP

S5 — SUBSTRATE UNLOADING STEP

S6 — TANK PURGE STEP

END

[Figure 4]

| Step | | 243a | 242a | 247a | 243f |
|---|---|---|---|---|---|
| S311 | S311-1 | open | close | close | close |
| | S311-2 | close | close | close | close |
| S312 | S312-1 | close | open | close | close |
| | S312-2 | close | open | open | close |
| | S312-3 | close | close | close | close |

[Figure 5]

| Step | | 243a | 242a | 247a | 243f |
|---|---|---|---|---|---|
| S6 | S6-1 | open | close | open | close |
| | S6-2 | open | close | close | open |
| | S6-3 | close | close | open | close |
| | S6-4 | close | close | close | close |

[Figure 6]

[Figure 7]

| Step | | 243a | 242a | 247a | 243f | 248a |
|---|---|---|---|---|---|---|
| S311' | S311-1' | open | close | close | close | open |
| | S311-2' | close | close | close | close | close |
| S312' | S312-1' | close | open | close | close | open |
| | S312-2' | close | open | open | close | close |
| | S312-3' | close | close | close | close | close |

[Figure 8]

| Step | | 243a | 242a | 247a | 243f | 248a |
|---|---|---|---|---|---|---|
| S6' | S6-1' | open | close | open | close | open |
| | S6-2' | open | close | close | open | open |
| | S6-3' | close | close | close | close | close |

**EP 4 786 635 A2**

**Patent documents cited in the description**

- JP 2004006801 A